# EUROPÄISCHE PATENTSCHRIFT

(11) **EP 2 331 436 B1**
(45) Veröffentlichungstag und Bekanntmachung des Hinweises auf die Patenterteilung: **26.12.2012**
(21) Anmeldenummer: 09748941.3
(22) Anmeldetag: 27.08.2009
(51) Int. Cl.: B65G 49/06

(54) **VERFAHREN UND VORRICHTUNG ZUM TRANSPORT GROSSFLÄCHIGER, DÜNNER GLASPLATTEN**
PROCESS AND APPARATUS TO CARRY THIN AND LARGE GLASS SHEETS.
PROCÉDÉ ET APPAREIL DE TRANSPORT DE FEUILLES DE VERRE LARGES ET FINES.

(30) Priorität: 02.09.2008 DE 102008045370; 24.10.2008 DE 102008053785
(43) Veröffentlichungstag der Anmeldung: 15.06.2011
(73) Patentinhaber: Grenzebach Maschinenbau GmbH, 86663 Asbach-Bäumenheim (DE)
(72) Erfinder: WEIGL, Helmut, 94315 Straubing (DE)
(74) Vertreter: Karl, Frank
(86) Internationale Anmeldenummer: PCT/DE2009/001202
(87) Internationale Veröffentlichungsnummer: WO 2010/025705

(56) Entgegenhaltungen:
- EP-A1- 0 506 198
- JP-A- 8 324 728
- US-A1- 2004 118 160
- US-A1- 2007 045 204
- US-A1- 2007 267 312

## Beschreibung

Die Erfindung betrifft eine Vorrichtung und ein Verfahren zum Transport großformatiger dünner Glasplatten unter Reinraumbedingungen zum Zweck der großtechnischen Herstellung elektrooptischer Produkte, insbesondere photovoltaischer Module oder TFT - Bildschirme sowie ein Computerprogramm und einen maschinenlesbaren Träger zur Durchführung des Verfahrens.

Moderne Glasfassaden sind vielfach nicht nur ein Funktionselement eines Baukörpers sondern dienen zunehmend auch zur solaren Stromerzeugung. Maßgeschneiderte Solarmodule ermöglichen die passgenaue Integration in Bauwerksraster und Profile. Semitransparente Solarzellen, aber auch opake Solarzellen mit transparenten Bereichen, lassen Photovoltaik - Verglasungen lichtdurchflutet erscheinen. Die Solarzellen übernehmen dabei häufig den gewünschten Effekt des Sonnen - und Blendschutzes.

Die Herstellung von solchen Photovoltaik - Anlagen erfordert Arbeitsbedingungen wie sie vor allem bei der Herstellung von Halbleitern und integrierten elektronischen Schaltungen üblich sind. Diese so genannten Reinraum - Bedingungen machen bei der Herstellung von Photovoltaik - Anlagen auch zusätzlich die Handhabung flächenmäßig großer stoßempfindlicher Glasplatten erforderlich.

Abgesehen davon sind große dünne Glasplatten, wie sie für die Fertigung großer TFT - Bildschirme verwendet werden, durch ihre Struktur und gleichzeitige relativ große Masse gegen kleinste Stöße äußerst empfindlich. Ein Industrieroboter ist deshalb auch aus den Gründen fehlender Feinfühligkeit und für solche Fälle mangelnder Positioniergenauigkeit zur Handhabung großer dünner Glasplatten in Reinsträumen nicht geeignet.

Besondere Aufmerksamkeit erfordert unter Reinstraum - Bedingungen die Umsetzung großer stoßempfindlicher Glasplatten von der horizontalen Ausrichtung in eine vertikale Ausrichtung. Ein weiterer Aspekt bei der Aufrechterhaltung von Reinstraum - Bedingungen, besonders bei der Fertigung kostenintensiver Produkte, ist die Kontaminationsgefahr durch den Menschen. Ein unbeabsichtigtes Niesen kann hierbei eine ganze Produktionseinheit zerstören. Ebenso erfordert eine derartige Anlage eine erhöhte Zuverlässigkeit. Da die Kosten für die Anschaffung und den Betrieb eines entsprechend ausgestalteten Industrie - Roboters hoch sind, ist auch der günstige Preis einer solchen Anlage wichtig.

Gerade bei der Handhabung großflächiger Glasplatten durch einen Industrie - Roboter ist zu beobachten, dass solche großen Flächen durch die Bewegung zum Schwingen neigen. Das kann zum einen bedingt sein durch die nur an wenigen Stellen anhaftenden Saugelemente und zum anderen durch die beschleunigten Bewegungsabläufe solcher Roboter. Bei derartigen Schwingungs - Erscheinungen ist die zusätzliche Gefahr eines Glasbruchs gegeben.

In der von der DE 19 18 791 A beschriebenen Vorrichtung zum Überführen und Stapeln von Platten soll die Überführungsgeschwindigkeit und die Stapelgeschwindigkeit von Platten gegenüber einem Stapelbetrieb nach dem Stand der Technik, der teilweise manuell unterstützt wird, beträchtlich erhöht werden. Dies geschieht im Wesentlichen dadurch, dass das Heben oder Umkehren jeder Platte in zwei Stufen ausgeführt wird. Um die jeweilige Platte bei dem hier beschriebenen Verfahren handhaben zu können wird sie fest mittels einer Saugeinrichtung verbunden, verschiedenen drehbaren Trageinrichtungen zugeführt und in verschiedene waagrechte und schräge Positionen verbracht bis sie endlich zu einem Stapelabschnitt überführt wird. Zu dem schonenden und sanften Transport von großformatigen, dünnen, stoßempfindlichen Glasplatten unter Reinraumbedingungen ergeben sich hierbei keine Anregungen.

Aus der DE 10 2005 039 453 A1 ist ferner eine Bearbeitungsanlage modularen Aufbaus für flächige Substrate bekannt geworden. Solche flächigen Substrate, zum Beispiel TFT - Bildschirme, sind aus Gründen des Verschmutzungsschutzes für die Handhabung unter atmosphärischen Sonderbedingungen auf Einhausungen angewiesen. Hierbei wird auf eine Einhausung der Bearbeitungsanlage verzichtet, dafür aber die modular aufgebaute Bearbeitungsanlage mit einer Transferanlage versehen, die sowohl einen schnellen Zugriff auf die einzelnen Module wie auch eine schnelle Umsetzung zwischen den einzelnen Modulen ermöglicht und über die ein Transfer der Substrate zwischen den Modulen auch unter Reinraumbedingungen ermöglicht wird. Das wird dadurch erreicht, dass die Transfereinheit eine die Substratauflage aufnehmende, als Einhausung ausgebildete Transferkammer aufweist, so dass die Größe der Einhausung auf die Größe des Substrates, und damit auf die unbedingt notwendige Größe reduziert werden kann. Hier handelt es sich zwar um Maßnahmen um eine Bearbeitungsanlage unter Reinraumbedingungen auf gewisse Weise zu optimieren, jedoch ist das Thema des Transports großformatiger, dünner, stoßempfindlicher Glasplatten nicht berührt.

Aus der den Oberbegriff der unabhängigen Ansprüche bildenden Druckschrift US 2004/118160 A1 ist eine Vorrichtung zum Transport großformatiger dünner Glasplatten unter Reinraumbedingungen zum Zweck der großtechnischen Herstellung elektrooptischer Produkte, insbesondere photovoltaischer Module oder TFT - Bildschirme, bekannt, mit den folgenden Merkmalen:
a) Förderelemente zur Anlieferung und zum weiteren Versenden von Glasplatten,
b) Bearbeitungselemente zur jeweiligen Bearbeitung von Glasplatten,
c) Fertigungslinien für die Zusammenführung einzelner Herstellungsprozesse,
d) Container zur Beladung mit, im Wesentlichen senkrecht stehenden, Glasplatten, wobei die Container von zwei gegenüber liegenden Seiten beladen und entladen werden können.

Aus der JP 08 324728 A ist eine Vorrichtung und ein Verfahren zum Ablagern und Liefern von Glasplatten bekannt.

Aus der EP 0506198 A1 ist ein mobiles Tragelement für Lagerräume, insbesondere für vertikal angeordnete Produkte in flacher Form bekannt, wobei ein auf Rädern gelagertes mobiles Element mit einem vertikal angeordneten Rahmen zur Aufnahme der zu lagernden Gegenstände eine Führungsstruktur für das mobile Element aufweist.

Der vorliegenden Erfindung liegt deshalb die Aufgabe zugrunde, eine Vorrichtung und ein Verfahren sowie ein Computerprogramm und einen maschinenlesbaren Träger zur Durchführung des Verfahrens anzugeben, womit bei der Ausrichtung und Positionierung großer dünner Glasplatten unter Reinraum - Bedingungen einen Fertigungsprozess bzw. eine Zulieferung zu einem bestimmten Fertigungsprozess gewährleistet werden kann, der ohne den Zutritt von Menschen, aber von Menschen außerhalb der Fertigung gesteuert und überwacht, erfolgt. Die entsprechende Vorrichtung muss zuverlässig sein und preiswert in der Herstellung. Die Bewegungsabläufe der Glasplatten müssen unerwünschte Schwingungen ausschließen.

Diese Aufgabe wird hinsichtlich der Vorrichtung durch die Merkmale nach Anspruch 1, hinsichtlich des Verfahrens durch die Maßnahmen nach Anspruch 7, hinsichtlich des Computerprogramms durch die Merkmale nach Patentanspruch 13 und bezüglich des maschinenlesbaren Trägers durch die Merkmale des Patentanspruchs 14 gelöst.

In den Unteransprüchen sind weitere vorteilhafte Ausführungsbeispiele der Erfindung gekennzeichnet.

Die erfindungsgemäße Vorrichtung wird im Folgenden näher beschrieben. Es zeigen im Einzelnen:
- Fig.1:: eine Darstellung der Fertigungsstruktur des Herstellungsprozesses,
- Fig.2:: einen Querschnitt eines Fahrwagens mit einem Container
- Fig.3:: eine Darstellung der Beladung eines Containers
- Fig.4:: eine Anzahl von Containern auf einem Lagerplatz
- Fig.5:: eine Darstellung einer weiteren Transportmöglichkeit
- Fig.6:: eine Schnittzeichnung einer weiteren Möglichkeit der Querabschiebung

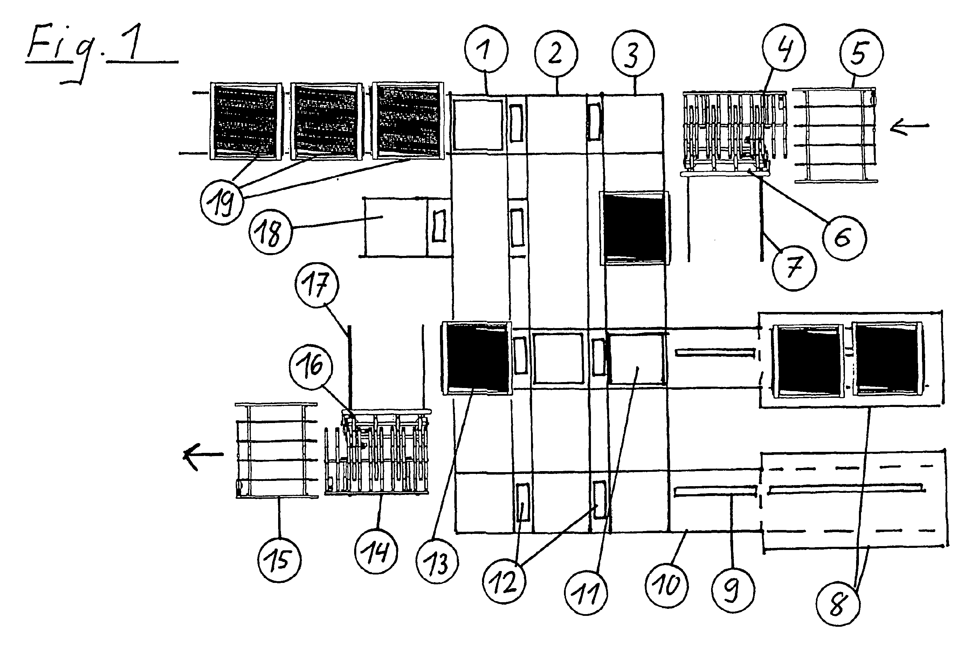

Am Beispiel der Fig.1 ist zum Transport großformatiger dünner Glasplatten unter Reinraumbedingungen zum Zweck der großtechnischen Herstellung elektrooptischer Produkte, insbesondere photovoltaischer Module oder TFT - Bildschirme, die Fertigungsstruktur des Herstellungsprozesses dargestellt.

Beispielhaft sind hier die Belade - Linie ( 3 ), die Entlade - Linie ( 1 ) und eine mittlere Übergabe - Linie (2) gezeigt, auf denen Fahrwagen ( 11 ) die jeweils Container ( 13 ) tragen, entsprechend den Anforderungen des jeweiligen Produktionsprozesses beladen, zwischengelagert oder entladen werden. Im Wesentlichen ist hierbei an die Produktion von photovoltaischen Modulen oder TFT - Bildschirmen gedacht. Es können jedoch auch andere vergleichbare Produkte hergestellt werden, da die Struktur der beschriebenen Vorrichtung sich nach dem jeweiligen Fertigungsprozess richtet. Die Container ( 13 ) sind besonders für den Transport großformatiger dünner Glasplatten geeignet, die für die Herstellung von photovoltaischen Modulen oder TFT-Bildschirmen benötigt werden.

In der rechten oberen Ecke der Fig.1 ist als Beispiel für eine mögliche Zubringungsart einer solchen Glasplatte ein Rollenförderer ( 4 ) und ein Bandförderer ( 5 ) dargestellt. Diesen Zubringungsarten ist eine Vorrichtung ( 6 ) zur Übergabe und Beladung zugeordnet, die auf den Schienen ( 7 ) bewegt wird.

Den gezeigten Zubringungsarten entspricht in der linken unteren Ecke der Fig.1 ein Rollenförderer (14) und ein Bandförderer (15) für den Weitertransport von Glasplatten nachdem sie die betreffende Arbeitsstufe, hier die Behandlung in einem Autoklaven ( 8 ) durchlaufen haben. Auch bei dem Weitertransport ist, entsprechend der Vorrichtung ( 6 ) eine Vorrichtung ( 16 ) zur Übergabe und Entladung zugeordnet, die auf den Schienen ( 17 ) bewegt wird.

Die Verbindungen zwischen der Belade - Linie ( 3 ), der Entlade - Linie ( 1 ) und der mittleren Übergabe - Linie ( 2 ) stellen die Übergabebrücken ( 12 ) dar. Diese können im einfachsten Fall aus einer Rolle bestehen, die die Querverschiebung von Fahrwagen ( 11 ) mit den aufliegenden Containern ( 11 ) ermöglichen. Der produktionsbedingt gesteuerte Antrieb der Fahrwagen ( 11 ) und das Querverschieben der Container ( 13 ) erfolgt über Antriebsmittel die hier nicht gezeigt sind. Beispielhaft ist hier lediglich der Antrieb ( 9 ) für die Übergabe zur Autoklav - Beschickung über die Schienen ( 10 ) dargestellt.

Für den Fall einer unvorhergesehenen Unterbrechung des Produktionsprozesses und dem daraus resultierenden Auflaufen von zu bearbeitenden Glasplatten, ist der Lagerplatz ( 19 ), gewissermaßen als Pufferspeicher, vorgesehen.

Der Platz ( 18 ) ist als Beispiel für die Lagerung von leeren Containern ( 13 ) und / oder den Lagerplatz für Glasbruch vorgesehen.

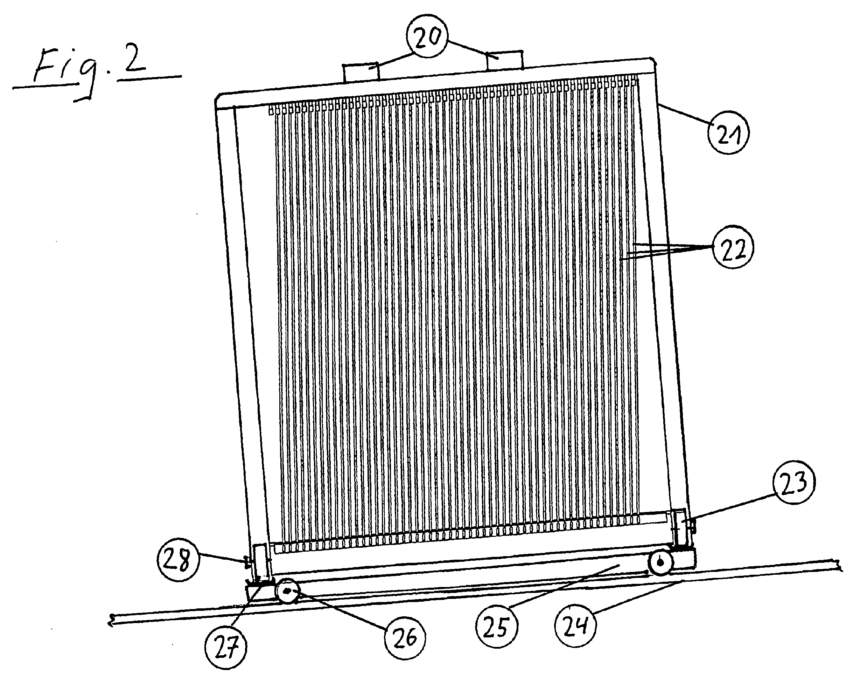

Fig.2 zeigt einen Querschnitt eines Fahrwagens ( 11 ) mit einem Container (13).

Der Fahrwagen (11) wird auf den Schienen ( 24 ) entsprechend des zu bewältigenden Produktionsprozesses über die Belade - Linie ( 3 ), die Entlade - Linie ( 1 ), und / oder die mittlere Übergabe - Linie ( 2 ) in Längsrichtung, wie in der Fig.1 gezeigt, bewegt. Ist ein solcher Fahrwagen ( 11 ) an seinem Bestimmungsort in Längsrichtung angelangt, wird der auf ihm befindliche Container ( 13 ) quer verfahren und an seine Zielposition verbracht.

Der Rahmen ( 25 ) eines Fahrwagens ( 11 ) trägt zu diesem Zweck die Schienenräder ( 26 ) die ihm eine Bewegung entlang der betreffenden Linien ( 3,2,1 ) ermöglichen.

Auf jedem Fahrwagen ( 11 ) befinden sich Querschienen ( 27 ) auf denen sich die Rollen ( 23 ) des jeweils darauf geladenen Containers ( 13 ) auf der Rollenachse ( 28 ) quer zur Fahrtrichtung des Fahrwagens ( 11 ) bewegen können.

Ein Container ( 13 ) besteht im Wesentlichen, im Querschnitt gesehen, aus einem Rahmen ( 21 ) in dem eine vertikale Fächertrennung ( 22 ) vorgesehen ist. Im einfachsten Fall besteht diese aus, längs des Containers ( 13 ) schräg eingepassten Querstreben, deren Abstand ein relativ schmales Fach ergeben. Dies ermöglicht, dass Glasplatten entsprechend der Breite der durch die Querstreben gebildeten Fächer schräg positioniert werden können.

Die Antriebe für das Längsverfahren der Fahrwagen (11) und das Querverfahren der Container ( 13 ) können auf konventionelle Weise über entsprechende Elektromotoren erfolgen. Solche Antriebsmöglichkeiten sind dem Fachmann bekannt.

Die Container ( 13 ) können von beiden Seiten beladen werden, indem mittels entsprechender Vorrichtungen zur Übergabe und Beladung, bzw. Entladung ( 6, 16 ) Glasplatten eingeschoben werden. Auf diese Weise ist es nicht erforderlich für den Vorgang des Beladens oder Entladens den betreffenden Container ( 13 ) zu drehen. Dies bedeutet eine Kostenersparnis bei der Installation der Fertigungsanlage durch die Einsparung zahlreicher Drehscheiben, wie sie bisher in vergleichbaren Fällen im Stand der Technik verwendet wurden, und eine Zeitersparnis bei der Produktion.

Für Notfälle sind an jedem Container ( 13 ) Transportlaschen ( 20 ) für einen manuellen Transport oder für einen Transport über einen Hebekran außerhalb der normalen Steuerung der Fertigung vorgesehen.

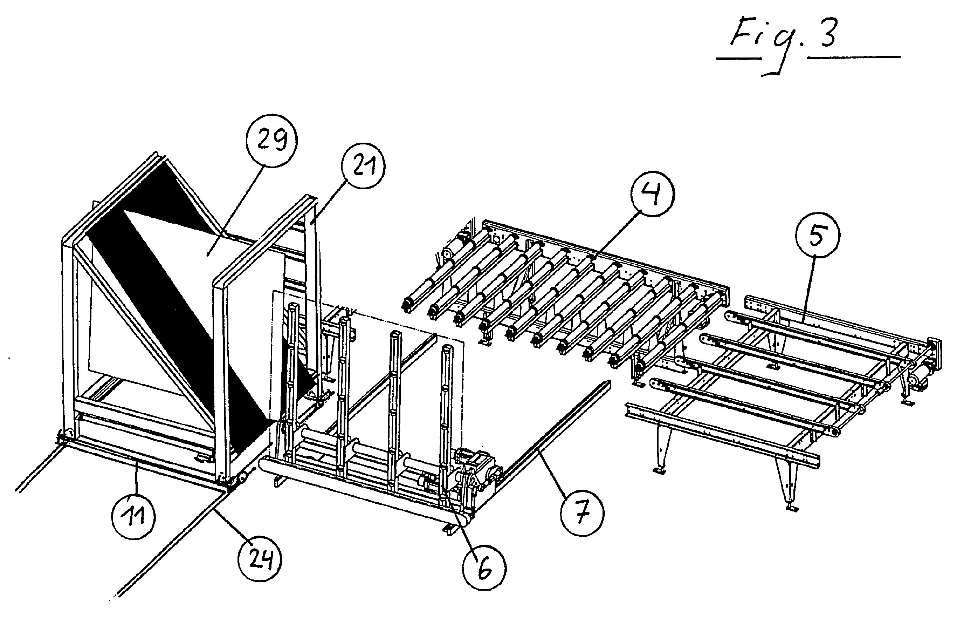

Die Fig.3 bringt eine Darstellung der Beladung eines Containers ( 13 ). Beispielhaft sind hierbei ein Rollenförderer ( 4 ) und ein Bandförderer ( 5 ) gezeigt, die eine, auf Schienen ( 7 ) laufende, Vorrichtung ( 6 ) zur Übergabe und Beladung mit einer Glasplatte beliefern.

Diese Vorrichtung besteht im Wesentlichen aus einer schwenkbaren Fläche zur Aufnahme der Glasplatte und einer Vorrichtung zur Übergabe der Glasplatte in einen Container ( 13 ). Dies geschieht mittels eines Vorgangs des Anhebens, der translatorischen Beförderung der Glasplatte in den vorderen Bereich des Containers (13), des dortigen Absenkens und der weiteren translatorischen Beförderung der Glasplatte in den hinteren Bereich des Containers ( 13 ). Die weitere Beförderung einer Glasplatte in den hinteren Bereich des jeweiligen Faches eines Containers ( 13 ) kann mittels eines Förderbandes erfolgen.

Im Beispiel der Fig.3 ist ein Solarmodul ( 29 ) in den vorderen Rahmen ( 21 ) eines Containers ( 13 ) auf einem Fahrwagen ( 11 ), der auf den Schienen ( 24 ) läuft, eingesetzt. Die dunkel gezeichnete diagonale Fläche innerhalb des Containers ( 13 ) kennzeichnet die Ebene der diagonal angelegten Fächertrennung ( 22 ).

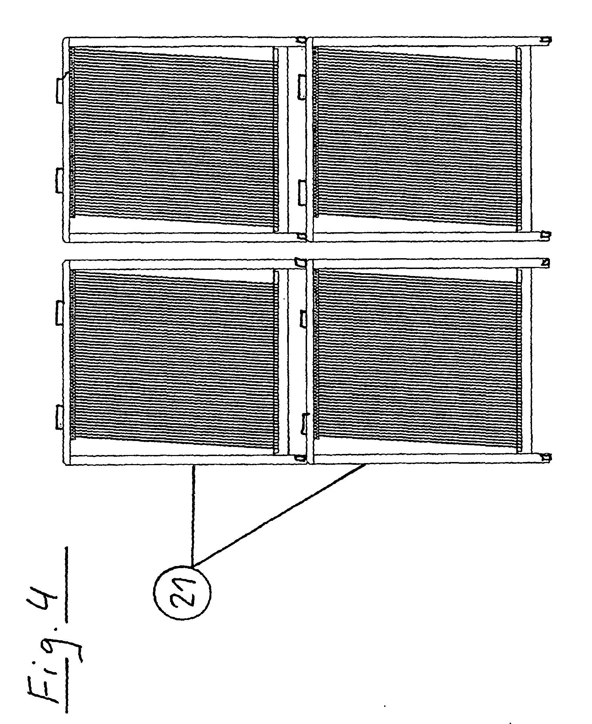

Die Fig.4 zeigt eine Anzahl von Containern ( 13 ) auf einem Lagerplatz. Die Rahmen ( 21 ) der Container ( 13 ) sind konstruktiv so gestaltet, dass sie einerseits stapelbar sind und andererseits der Belastung einer Anordnung in mehrfacher Überdeckung gewachsen sind.

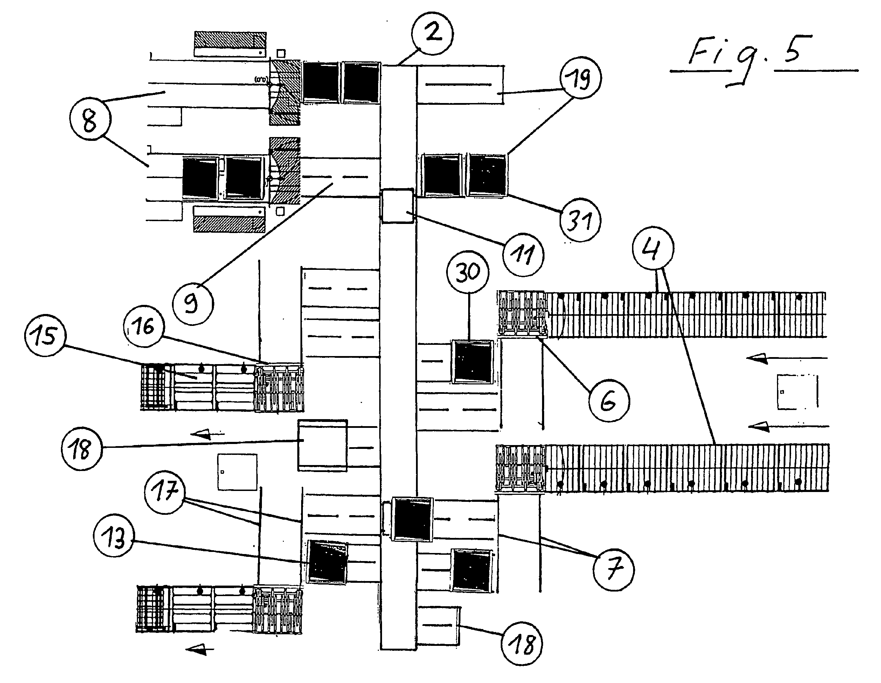

Die Fig. 5 bringt eine Darstellung einer weiteren Transportmöglichkeit, mit der die der Erfindung zugrunde liegende Aufgabe auf eine vergleichbare Weise gelöst wird.

Anstelle der in der Fig.1 gezeigten Belade - Linie ( 3 ), der Entlade - Linie ( 1 ) und der mittleren Übergabe - Linie ( 2 ) wird hierbei lediglich von einer Übergabe - Linie ( 2 ) ausgegangen.

Auf diese Weise werden zwar einerseits Übergabebrücken ( 12 ) gemäß der Vorrichtung in der Fig.1 eingespart, aber andererseits sind weitere Wege zu den einzelnen Bearbeitungsstationen notwendig.

Auf der rechten Seite der Fig.5 sind beispielhaft zwei parallel verlaufende Rollenförderer ( 4 ) als mögliche Zubringungsart für zu bearbeitende Glasplatten mit ihren jeweiligen Vorrichtungen ( 6 ) zur Übergabe und Beladung und den zugehörigen Schienen ( 7 ) gezeigt. Im Bereich der Vorrichtungen ( 6 ) sind zwei mit dem Bezugszeichen ( 30 ) bezeichnete Container ( 13 ) in der Position des Beladens dargestellt.

Für den Fall einer unvorhergesehenen Unterbrechung des Produktionsprozesses und den daraus resultierenden Auflaufen von zu bearbeitenden Glasplatten, sind auch hier die Lagerplätze ( 19 ), gewissermaßen als Pufferspeicher, vorgesehen. Ein solcherart gelagerter Container ist mit ( 31 ) bezeichnet.

Der Platz (18) ist ebenfalls, wie in der Fig.1, als Beispiel für die Lagerung von leeren Containern (13) und / oder den Lagerplatz für Glasbruch vorgesehen.

Auf der linken Seite der zentralen mittleren Übergabe - Linie ( 2 ) sind auch im Falle der Fig.5 Bandförderer ( 15 ) mit der zugehörigen Vorrichtung ( 16 ) zur Übergabe und Entladung und deren Laufschienen ( 17 ) zu erkennen. Im Bereich des unteren Bandförderers (15) ist ein Container ( 13 ) zur Weiterbeförderung sowie ein weiterer Platz ( 18 ) für die Lagerung von leeren Containern ( 13 ) und /oder den Lagerplatz für Gasbruch dargestellt.

Der in der Fig.5 gezeigte Antrieb (9) für die Übergabe an die beiden Autoklaven ( 8 ) in der linken oberen Ecke weist eine andere Form der Darstellung auf als in der Fig.1. Das hat seinen Grund darin, dass, anders als bei der Antriebsart in der Fig.1, der Antrieb für die Querverschiebung eines Containers ( 13 ) über den jeweiligen Fahrwagen ( 11 ) selbst erfolgt. Auf diese Weise lassen sich lange Transüorwege von der in der Fig.5 gezeigten mittleren Übergabe - Linie ( 2 ) zu dem jeweiligen Bestimmungsort eines Containers ( 13 ) realisieren.

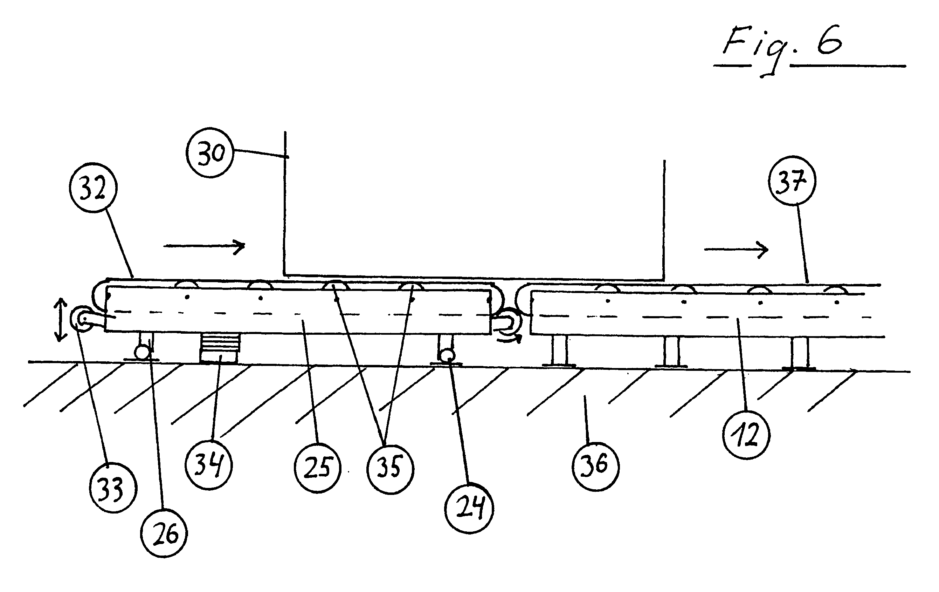

Eine nähere Erläuterung hierzu gibt die Fig.6, in der eine Schnittzeichnung einer weiteren Möglichkeit der Querabschiebung gezeigt wird, die vorteilhaft bei der Verwendung lediglich einer mittleren Übergabe - Linie verwendet wird.

Bei dieser Lösung erfolgt die Querverschiebung eines Containers ( 30 ) in Beladeposition über ein Transportband ( 32 ), das im Rahmen ( 25 ) eines Fahrwagens ( 11 ) über Tragrollen (35) quer zu seiner Fahrtrichtung bewegt wird. Die Fahrtrichtung des Fahrwagens ( 11 ) wird in der Fig.6 durch die im Querschnitt gezeichneten Schienen ( 24 ) und die Schienenräder 26) festgelegt. Die Antriebsenergie und die Steuerung des entsprechenden, nicht näher bezeichneten, Motors erfolgt über die Versorgungsleitung ( 34 ), die sich entsprechend der Position des Fahrwagens ( 11 ) kettenartig mehr oder weniger entrollt.

Ein wesentlicher Bestandteil des beschriebenen Antriebskonzepts ist die Wirkung der Andruckrolle ( 33 ) zur Kraftübertragung auf die in der Fig.6 gezeigte Übergabebrücke ( 12 ). Wie auf der linken Seite der Fig.6 durch den Doppelpfeil gezeigt, kann die Andruckrolle ( 33 ) mittels eines, der Übersicht wegen nicht eingezeichneten, separat ansteuerbaren, Stellmotors aufwärts und abwärts in eine obere Position und eine untere Position bewegt werden. Auf diese Weise wird bei einer Stellung der Andruckrolle ( 33 ) in der oberen Position erreicht, dass das angetriebene Transportband ( 32 ) kraftschlüssig mit einem weiteren Transportband (37) für eine Übergabebrücke ( 12 ) verbunden wird. So kann ein Container ( 30 ) über weitere Übergabebrücken ( 12 ) mit optional weiteren steuerbaren Andruckrollen ( 33 ) lediglich durch die Kraft eines im Rahmen ( 25 ) eines Fahrwagens ( 11 ) befindlichen Motors angetrieben werden. Auf diese Weise können zusätzliche Antriebe eingespart werden. Im Wesentlichen wird jedoch meist die Kraftübertragung auf eine, mehr oder weniger lange, Übergabebrücke ( 12 ) ausreichen.

Da es für die Steuerung der Fertigung mittels der erfindungsgemäßen Vorrichtung notwendig ist, zu jedem Zeitpunkt exakte Informationen über den Status jedes Anlagenteils zu erhalten, wird mittels entsprechender Sensoren und datentechnischer Übermittlung eine zeitlich und örtlich exakte Ankopplung einer gewünschten Übergabebrücke ( 12 ) erreicht.

Der gezeigte Bearbeitungsvorgang der Glasplatten betrifft lediglich beispielhaft die Bearbeitung in einem Autoklaven. Sämtliche anderen Bearbeitungsvorgänge, wie zum Beispiel das Schneiden der Glasplatten, das Zwischenlegen von Folien zwischen zwei Glasplatten, deren Besäumen oder das Aufbringen einer photovoltaisch wirksamen Schicht, werden hinsichtlich des Transports von und zu den Stätten der jeweiligen Bearbeitung auf dieselbe Weise vorgenommen. Auch in diesen Fällen liefern entsprechende Sensoren die jeweils relevanten Daten an die Steuerungszentrale der gesamten Fabrikanlage.

Die interaktive Steuerung der jeweils verwendeten Bewegungselemente und Sensoren erfordert ein spezielles Steuerungsprogramm.

### Bezugszeichenliste

( 1 ) Entlade - Linie
( 2 ) mittlere Übergabe - Linie
( 3 ) Belade - Linie
( 4 ) Rollenförderer (Eingang)
( 5 ) Bandförderer (Eingang)
( 6 ) Vorrichtung zur Übergabe und Beladung
( 7 ) Schienen der Vorrichtung zur Übergabe und Beladung
( 8 ) Autoklav
( 9 ) Antrieb für die Übergabe zur Autoklav - Beschickung
( 10 ) Querschienen zum Autoklav
( 11 ) Fahrwagen für Scheiben - Container
( 12 ) Übergabebrücke (Querübergabe vom Container)
( 13 ) Container (Entladeposition)
( 14 ) Rollenförderer für Weitertransport
( 15 ) Bandförderer für Weitertransport
( 16 ) Vorrichtung zur Übergabe und Entladung
( 17 ) Schienen der Vorrichtung zur Übergabe und Entladung
( 18 ) Platz der Container - Entnahme oder Glasbruchentsorgung
( 19 ) Lagerplatz für Container (Pufferung bei auflaufender Fertigung)
( 20 ) Transportlaschen für manuellen Transport
( 21 ) Container-Rahmen
( 22 ) Fächertrennung (Querstreben)
( 23 ) Rollen am Container für Querverschiebung
( 24 ) Schienen für Fahrwagen
( 25 ) Rahmen des Fahrwagens
( 26 ) Schienenräder des Fahrwagens
( 27 ) Querschiene auf dem Fahrwagen
( 28 ) Rollenachse des Containers
( 29 ) Solar - Modul
( 30 ) Container in einer Beladeposition
( 31 ) Lagerplatz für Container (Pufferung bei auflaufender Fertigung)
( 32 ) Transportband des Fahrwagens (Querverschiebung)
( 33 ) Andruckwelle zur Kraftübertragung
( 34 ) Versorgungsleitung (kettenförmig)
( 35 ) Tragrollen für das Transportband
( 36 ) Werkboden
( 37 ) Transportband für eine Übergabebrücke

## Patentansprüche

1. Vorrichtung zum Transport großformatiger dünner Glasplatten unter Reinraumbedingungen zum Zweck der großtechnischen Herstellung elektrooptischer Produkte, insbesondere photovoltaischer Module oder TFT - Bildschirme,
aufweisend:
a) Förderelemente zur Anlieferung (4, 5) und zum weiteren Versenden (14, 15) von Glasplatten,
b) Bearbeitungselemente (8) zur jeweiligen Bearbeitung von Glasplatten,
c) Fertigungslinien (1, 2, 3) für die Zusammenführung einzelner Herstellungsprozesse,
d) Container (13) zur Beladung mit, im Wesentlichen senkrecht, stehenden Glasplatten, wobei die Container (13) von zwei gegenüber liegenden Seiten beladen und entladen werden können,
**dadurch gekennzeichnet**,
e) dass Fahrwagen (11) zur Beförderung der Container (13) vorhanden sind, wobei die Fahrwagen (11) einerseits Schienenräder (26) aufweisen und andererseits Querschienen (28) zur Führung der Rollen (23) für die Verschiebung der Container (13) tragen,
f) dass Mittel zum Antrieb der Fahrwagen (11) und der Querverschiebung der Container (13) entsprechend der produktionstechnischen Erfordernisse mit gemeinsamen Antriebsmotoren vorhanden sind.

2. Vorrichtung nach Anspruch 1,
**dadurch gekennzeichnet,**
**dass** die Mittel zur Querverschiebung der Container (13) über einen eigenen im Fahrwagen (11) angeordneten Motor verfügen.

3. Vorrichtung nach einem der Ansprüche 1 oder 2,
**dadurch gekennzeichnet,**
**dass** alle bewegbaren Elemente, als Teil einer großräumigen Fabrikanlage, aus abriebgeschütztem Material bestehen und alle Antriebe hinsichtlich des Abriebs bewegter Teile emissionsgeschützt sind.

4. Vorrichtung nach Anspruch 2 oder 3,
**dadurch gekennzeichnet,**
**dass** das Mittel zur Querverschiebung aus einem Transportband (32) besteht, das von einem im Fahrwagen (11) befindlichen Motor angetrieben wird.

5. Vorrichtung nach Anspruch 4,
**dadurch gekennzeichnet,**
**dass** das Transportband (32) mittels einer steuerbaren Andruckrolle (33) ein Transportband (37) einer Übergabebrücke (12) antreibt.

6. Vorrichtung nach einem der Ansprüche 1 bis 5,
**dadurch gekennzeichnet,**
**dass** alle relevanten Parameter des Fertigungsprozesses mittels Sensoren erfasst und zur Steuerung des Fertigungsprozesses verwendet werden.

7. Verfahren zum Transport großformatiger dünner Glasplatten unter Reinraumbedingungen zum Zweck der großtechnischen Herstellung elektrooptischer Produkte, insbesondere photovoltaischer Module oder TFT - Bildschirme,
mit den folgenden Merkmalen:
a) es werden Förderelemente zur Anlieferung (4, 5) und zum weiteren Versenden (14, 15) von Glasplatten eingerichtet,
b) für jeden Bearbeitungsschritt werden Bearbeitungselemente (8) zur jeweils geplanten Bearbeitung von Glasplatten vorgesehen,
c) für die Herstellung eines elektrooptischen Produkts werden Fertigungslinien (1, 2, 3) für die Zusammenführung einzelner Herstellungsprozesse eingerichtet,
d) der Transport der Glasplatten erfolgt über Container (13), die mit, im Wesentlichen senkrecht, stehenden Glasplatten, bestückt werden, wobei die Container (13) von zwei gegenüber liegenden Seiten beladen und entladen werden können,
**dadurch gekennzeichnet**,
e) dass die Beförderung der Container (13) über Fahrwagen (11) erfolgt, wobei die Fahrwagen (11) einerseits für ihre eigene Bewegung Schienenräder (26) aufweisen und andererseits selbst Querschienen (28) zur Führung der Rollen (23) zur Verschiebung der auf ihnen beförderten Container (13) tragen,
f) dass die Mittel zum Antrieb der Fahrwagen (11) und der Querverschiebung der Container (13) entsprechend der produktionstechnischen Erfordernisse von einem gemeinsamen Antrieb gesteuert werden.

8. Verfahren nach Anspruch 7,
**dadurch gekennzeichnet,**
**dass** die Mittel zur Querverschiebung der Container (13) über einen eigenen, im Fahrwagen (11) angeordneten Motor wirken.

9. Verfahren nach einem der Ansprüche 7 oder 8,
**dadurch gekennzeichnet,**
**dass** alle bewegbaren Elemente, als Teil einer großräumigen Fabrikanlage, aus abriebgeschütztem Material bestehen und alle Antriebe hinsichtlich des Abriebs bewegter Teile emissionsgeschützt sind.

10. Verfahren nach einem der Ansprüche 7 bis 9,
**dadurch gekennzeichnet,**
**dass** das Mittel zur Querverschiebung aus einem Transportband (32) besteht, das von einem im Fahrwagen (11) befindlichen Motor angetrieben wird.

11. Verfahren nach Anspruch 10,
**dadurch gekennzeichnet,**
**dass** das Transportband (32) mittels einer steuerbaren Andruckrolle (33) ein Transportband (37) einer Übergabebrücke (12) antreibt.

12. Verfahren nach einem der Ansprüche 7 bis 11,
**dadurch gekennzeichnet,**
**dass** alle relevanten Parameter des Fertigungsprozesses mittels Sensoren erfasst und zur Steuerung des Fertigungsprozesses verwendet werden.

13. Computerprogramm mit einem Programmcode zur Durchführung der Verfahrensschritte nach einem der Ansprüche 7 bis 12, wenn das Programm in einem Computer ausgeführt wird.

14. Maschinenlesbarer Träger mit dem Programmcode eines Computerprogramms zur Durchführung des Verfahrens nach einem der Ansprüche 7 bis 12, wenn das Programm in einem Computer ausgeführt wird.

## Claims

1. Apparatus for transporting large-format, thin glass plates under clean room conditions for the purpose of the industrial production of electro-optical products, in particular photovoltaic modules or TFT screens, comprising:
a) conveying elements for supplying (4, 5) and for further forwarding (14, 15) glass plates,
b) processing elements (8) for respectively processing glass plates,
c) manufacturing lines (1, 2, 3) for combining individual production processes,
d) containers (13) for loading with substantially vertical glass sheets, it being possible for the containers (13) to be loaded and unloaded from two opposite sides,
**characterized in that**
e) carriages (11) for conveying the containers (13) are present, the carriages (11) having, on the one hand, rail wheels (26) and bearing, on the other hand, transverse rails (28) for guiding the rollers (23) in order to displace the containers (13),
f) **in that** means for driving the carriages (11) and transversely displacing the containers (13) according to the production requirements that comprise common drive motors are present.

2. Apparatus according to Claim 1, **characterized in that** the means for transversely displacing the containers (13) have a dedicated motor arranged in the carriage (11).

3. Apparatus according to either of Claims 1 and 2, **characterized in that** all the movable elements, as part of a large-area factory installation, consist of abrasion-protected material and all the drives are emission-protected with respect to the wear of moving parts.

4. Apparatus according to Claim 2 or 3, **characterized in that** the means for transverse displacement consists of a conveyor belt (32) which is driven by a motor situated in the carriage (11).

5. Apparatus according to Claim 4, **characterized in that** the conveyor belt (32) drives a conveyor belt (37) of a transfer bridge (12) by means of a controllable pressure roller (33).

6. Apparatus according to one of Claims 1 to 5, **characterized in that** all the relevant parameters of the manufacturing process are detected by means of sensors and used for controlling the manufacturing process.

7. Method for conveying large-format, thin glass sheets under clean room conditions for the purpose of the industrial production of electro-optical products, in particular photovoltaic modules or TFT screens, comprising the following features:
a) conveying elements for supplying (4, 5) and for further forwarding (14, 15) glass plates are set up,
b) processing elements (8) for the respectively planned processing of glass plates are provided for each processing step,
c) manufacturing lines (1, 2, 3) for combining individual production processes are set up for the production of an electro-optical product,
d) the glass plates are transported via containers (13) which are equipped with substantially vertical glass plates, it being possible for the containers (13) to be loaded and unloaded from two opposite sides,
**characterized in that**
e) the containers (13) are conveyed via carriages (11), the carriages (11) having, on the one hand, rail wheels (26) for their own movement and themselves bearing, on the other hand, transverse rails (28) for guiding the rollers (23) in order to displace the containers (13) conveyed thereon,
f) the means for driving the carriages (11) and transversely displacing the containers (13) are controlled by a common drive according to the production requirements.

8. Method according to Claim 7, **characterized in that** the means for transversely displacing the containers (13) act via a dedicated motor arranged in the carriage (11).

9. Method according to either of Claims 7 and 8, **characterized in that** all the movable elements, as part of a large-area factory installation, consist of abrasion-protected material and all the drives are emission-protected with respect to the abrasion of moving parts.

10. Method according to one of Claims 7 to 9, **characterized in that** the means for transverse displacement consists of a conveyor belt (32) which is driven by a motor situated in the carriage (11).

11. Method according to Claim 10, **characterized in that** the conveyor belt (32) drives a conveyor belt (37) of a transfer bridge (12) by means of a controllable pressure roller (33).

12. Method according to one of Claims 7 to 11, **characterized in that** all the relevant parameters of the manufacturing process are detected by means of sensors and used for controlling the manufacturing process.

13. Computer program having a program code for implementing the method steps according to one of Claims 7 to 12 when the program is executed in a computer.

14. Machine-readable carrier having the program code of a computer program for implementing the method according to one of Claims 7 to 12 when the program is executed in a computer.

## Revendications

1. Dispositif de transport de minces plaques de verre de grand format dans des conditions de local propre en vue de la fabrication en grande série de produits électro-optiques, en particulier de modules photovoltaïques ou d'écrans TFT,
le dispositif présentant :
a) des éléments de transport qui apportent (4, 5) et renvoient (14, 15) les plaques de verre,
b) des éléments de traitement (8) qui assurent les différents traitements des plaques de verre,
c) des lignes de fabrication (1, 2, 3) qui réunissent les différentes opérations de fabrication,
d) des conteneurs (13) destinés à être chargés de plaques de verre posées essentiellement à la verticale, les conteneurs (13) pouvant être chargés et déchargés de deux côtés opposés,
**caractérisé en ce que**
e) des chariots (11) de transport des conteneurs (13) sont prévus, les chariots (11) présentant d'une part des roues (26) pour rails et d'autre part des rails transversaux (28) qui guident les galets (23) en vue de déplacer les conteneurs (13) et
f) **en ce que** les moyens d'entrainement des chariots (11) et du déplacement transversal des conteneurs (13) en correspondance aux besoins techniques de la production et présentant des moteurs d'entraînement commun sont prévus.

2. Dispositif selon la revendication 1, **caractérisé en ce que** les moyens de déplacement transversal des conteneurs (13) disposent d'un moteur propre disposé dans le chariot (11).

3. Dispositif selon l'une des revendications 1 ou 2, **caractérisé en ce que** tous les éléments mobiles qui font partie d'une installation de fabrication de grande taille sont constitués de matériaux protégés contre l'usure et **en ce que** tous les entraînements sont protégés des émissions par les parties d'usure mobiles.

4. Dispositif selon les revendications 2 ou 3, **caractérisé en ce que** le moyen de transport transversal est constitué d'une bande transporteuse (32) entraînée par un moteur situé dans le chariot (11).

5. Dispositif selon la revendication 4, **caractérisé en ce que** la bande transporteuse (32) entraîne une bande transporteuse (37) d'un portique de transfert (12) au moyen d'un rouleau de poussée (33) asservi.

6. Dispositif selon l'une des revendications 1 à 5, **caractérisé en ce que** tous les paramètres intervenant dans le procédé de fabrication sont détectés au moyen de détecteurs et sont utilisés pour commander le procédé de fabrication.

7. Procédé de transport de minces plaques de verre de grand format dans des conditions de local propre en vue de la fabrication en grande série de produits électro-optiques, en particulier de modules photovoltaïques ou d'écrans TFT,
le procédé présentant les caractéristiques suivantes :
a) des éléments de transport sont prévus pour délivrer (4, 5) et pour envoyer plus loin (14, 15) des plaques de verre,
b) pour chaque étape de traitement, des éléments de traitement (8) sont prévus pour le traitement programmé correspondant de plaques de verre,
c) pour la fabrication d'un produit électro-optique, des lignes de fabrication (1, 2, 3) sont conçues pour réunir les différentes opérations de fabrication,
d) le transport des plaques de verre s'effectue par des conteneurs (13) équipés de plaques de verre posées essentiellement à la verticale, les conteneurs (13) pouvant être chargés et déchargés de deux côtés opposés,
**caractérisé en ce que**
e) le transport des conteneurs (13) s'effectue par l'intermédiaire de chariots (11), les chariots (11) présentant pour leur propre déplacement des roues (26) à rails, d'une part, et d'autre part portent eux-mêmes des rails transversaux (28) qui guident les galets (23) de déplacement des conteneurs (13) transportés sur eux et
f) **en ce que** les moyens d'entraînement des chariots (11) et du déplacement transversal des conteneurs (13) sont commandés par un entraînement commun en correspondance aux besoins techniques de la production.

8. Procédé selon la revendication 7, **caractérisé en ce que** les moyens de déplacement transversal des conteneurs (13) agissent par l'intermédiaire d'un moteur propre disposé dans le chariot (11).

9. Procédé selon l'une des revendications 7 ou 8, **caractérisé en ce que** tous les éléments mobiles qui font partie d'une installation de fabrication de grande taille sont constitués de matériaux protégés contre l'usure et **en ce que** tous les entraînements sont protégés des émissions par les parties d'usure mobiles.

10. Procédé selon l'une des revendications 7 à 9, **caractérisé en ce que** le moyen de transport transversal est constitué d'une bande transporteuse (32) entraînée par un moteur situé dans le chariot (11).

11. Procédé selon la revendication 10, **caractérisé en ce que** la bande transporteuse (32) entraîne une bande transporteuse (37) d'un portique de transfert (12) au moyen d'un rouleau de poussée (33) asservi.

12. Procédé selon l'une des revendications 7 à 11, **caractérisé en ce que** tous les paramètres intervenant dans le procédé de fabrication sont détectés au moyen de détecteurs et sont utilisés pour commander le procédé de fabrication.

13. Programme informatique doté d'un code de programme en vue de l'exécution des étapes du procédé selon l'une des revendications 7 à 12 lorsque le programme est exécuté sur un ordinateur.

14. Support lisible par machine et présentant le code de programme d'un programme informatique permettant d'exécuter le procédé selon l'une des revendications 7 à 12 lorsque le programme est exécuté sur un ordinateur.
